# FASCICULE DE BREVET EUROPEEN

(11) **EP 1 051 739 B1**
(45) Date de publication et mention de la délivrance du brevet: **26.07.2017**
(21) Numéro de dépôt: 99901662.9
(22) Date de dépôt: 29.01.1999
(51) Int. Cl.: H01L 21/20

(54) **SUBSTRAT COMPLIANT EN PARTICULIER POUR UN DEPOT PAR HETERO-EPITAXIE**
NACHGIEBIGES SUBSTRAT INSBESONDERE FÜR EINE HETEROEPITAKTISCHE ABSCHEIDUNG
COMPLIANT SUBSTRATE IN PARTICULAR FOR DEPOSIT BY HETERO-EPITAXY

(30) Priorité: 30.01.1998 FR 9801061
(43) Date de publication de la demande: 15.11.2000
(73) Titulaire: Commissariat à l'Énergie Atomique et aux Énergies Alternatives, 75015 Paris (FR)
(72) Inventeur: ASPAR, Bernard, F-38140 Rives (FR); BRUEL, Michel, F-38113 Veurey (FR); JALAGUIER, Eric, F-38240 Saint Martin d'Uriage (FR); MORICEAU, Hubert, F-38120 Saint Egrève (FR)
(74) Mandataire: Moutard, Pascal Jean
(86) Numéro de dépôt international: PCT/FR1999/000187
(87) Numéro de publication internationale: WO 1999/039377

(56) Documents cités:
- EP-A- 0 412 002
- EP-A1- 0 671 639
- EP-A1- 0 711 854
- EP-A1- 0 977 252
- EP-A2- 0 663 688
- WO-A1-03/083930
- FR-A- 2 681 472
- FR-A1- 2 681 472
- FR-A1- 2 692 368
- JP-A- 4 012 092
- US-A- 4 845 044
- US-A- 5 205 871
- US-A- 5 240 876
- US-A- 5 281 834
- EJECKAM F E ET AL: "LATTICE ENGINEERED COMPLIANT SUBSTRATE FOR DEFECT-FREE HETEROEPITAXIAL GROWTH" APPLIED PHYSICS LETTERS, vol. 70, no. 13, 31 mars 1997, pages 1685-1687, XP000689465 cité dans la demande
- MOLNAR R.J. ET AL: 'Growth of gallium nitride by hydride vapor-phase epitaxy' JOURNAL OF CRYSTAL GROWTH vol. 178, 1997, pages 147 - 156, XP004084981
- DI CIOCCIO L. ET AL: 'Silicon carbide on insulator formation by the Smart-Cut(R) process' MATERIALS SCIENCE AND ENGINEERING vol. B46, 1997, pages 349 - 356, XP004085343
- RAYSSAC O.; IGNAT M.: 'ETUDE DU COLLAGE PAR ADHESION MOLECULAIRE HYDROPHILE: APPLICATION AU CONTROLE DE L'ENERGIE DE COLLAGE' CAT. INIST 2007,

## Description

### Domaine technique

La présente invention concerne un procédé de croissance par hétéro-épitaxie mettant en oeuvre un substrat compliant, c'est-à-dire un substrat capable d'accepter des contraintes induites par une structure qui y adhère et qui peut être une couche déposée sur une surface de ce substrat par hétéro-épitaxie de telle façon que cette couche souffre le moins possible des contraintes.

### Etat de la technique antérieure

Les applications électroniques et optoélectroniques demandent un nombre croissant de matériaux semiconducteurs et en particulier de semiconducteurs composés comme par exemple ceux du type III-V. Cependant, actuellement on ne sait fabriquer des substrats massifs que pour certains semiconducteurs tels que par exemple le silicium, l'arséniure de gallium, le carbure de silicium et le phosphure d'indium. Pour d'autres semiconducteurs la solution retenue est la croissance hétéro-épitaxiale sur un substrat dont le réseau cristallin est adapté à celui de la couche semi-conductrice à faire croître.

Cependant, cette contrainte d'adaptation des paramètres de maille au niveau de l'interface de croissance entre couche et substrat limite sévèrement le nombre et la diversité des couches que l'on peut ainsi faire croître, car il n'est que rarement possible de trouver le substrat dont le réseau soit adapté à la couche désirée. Ainsi, par exemple, il n'existe pas de substrats massifs parfaitement adaptés à la croissance hétéro-épitaxiale de GaN, de AlN et InN.

L'utilisation de substrats mal adaptés conduit à la croissance de couches de très mauvaise qualité. En particulier, dès que l'épaisseur de la couche dépasse une valeur critique d'autant plus faible que les réseaux sont désadaptés, les contraintes se relâchent dans la couche hétéro-épitaxiale par création de défauts de structures (en particulier des dislocations).

Pour s'affranchir de ces problèmes, les spécialistes de l'épitaxie sur substrats épais ont utilisé des techniques de croissance incluant la réalisation d'un empilement de couches tampons dont l'objectif est de permettre d'absorber les contraintes induites par la différence de paramètres de maille entre le substrat et la couche épitaxiée principalement dans le plan d'épitaxie et par la différence de coefficients de dilatation thermique entre les deux matériaux. Dans ce dernier cas, la température d'élaboration de la couche épitaxiée est également un paramètre à prendre en compte. Cet empilement de couches tampons se termine par une couche superficielle servant alors à la germination de la couche épitaxiée qui est la couche désirée. Cependant, même en utilisant tout ce savoir-faire, les matériaux obtenus contiennent toujours des défauts cristallins et ont souvent des qualités insuffisantes pour la réalisation de dispositifs optoélectroniques et/ou électroniques.

Pour remédier à ce problème, différentes études sur le substrat compliant ont été menées. On peut citer à titre d'exemple l'article "New Approach to Grow Pseudomorphic Structures over the Critical Thickness" par Y.H. LO paru dans la revue Appl. Phys. Lett. 59 (18), 28 octobre 1991. Dans ce domaine, le substrat compliant est par essence un substrat cristallin dont la maille cristalline (paramètre de maille) n'est pas nécessairement adapté à la couche que l'on veut faire croître, mais qui possède la propriété, lorsque l'on fait croître la couche hétéro-êpitaxiale, de relaxer les contraintes liées à la croissance de la couche, dans le substrat compliant lui-même ou à l'interface, au lieu de laisser les contraintes se relaxer dans la couche hétéro-épitaxiale. On obtient ainsi des couches hétéro-épitaxiales de très grande qualité et dans le principe, le substrat compliant permet la croissance de tout type de couche sur un réseau cristallin.

On peut classer la réalisation de substrats compliants selon trois groupes.

Un premier groupe se rapporte à un substrat très fin (quelques nm) et autoporteur, ce qui est très difficile à réaliser et même quasiment impossible si l'on veut obtenir de grandes surfaces. On pourra se reporter à ce sujet à l'article "Lattice Engineered Compliant Substrate for Defect-free Hetero-epitaxial Growth" de F.E. EJECKAM et al., paru dans la revue Appl. Phys. Lett. 70 (13), 31 mars 1997.

Un deuxième groupe se rapporte à une structure SOI (Silicium-Sur-Isolant) sur un substrat. Dans cas, le film superficiel obtenu est très fin et la couche isolante sous-jacente est susceptible de se déformer sous l'effet de la température pendant la croissance du film mince.

Un troisième groupe se rapporte à une structure du type dit "twist bonding" dans la terminologie anglo-saxonne. Dans ce cas, le film mince, permettant la relaxation des contraintes appelée par la suite compliance, est réalisé au moyen d'un collage, par adhésion moléculaire, de deux substrats cristallins de même type, dont les réseaux cristallins sont désorientés, et en amincissant l'un d' eux jusqu' à ne laisser qu'une couche très fine. On pourra se reporter à ce sujet à l'article "Dislocation-free InSb Grown on GaAs Compliant Universal Substrates" de F.E. EJECKAM et al., paru dans la revue Appl. Phys. Lett. 71 (6), 11 août 1997. Ce collage avec désorientation induit au voisinage de l'interface la formation de dislocations qui se retrouvent dans la couche amincie, rendant celle-ci capable d'accommoder les contraintes lorsque l'on fait croître une couche hétéro-épitaxiale dessus.

Ces substrats compliants selon l'art connu présentent certaines limitations dans leur utilisation. Pour le film autoporteur, la limitation réside dans la difficulté ou la quasi-impossibilité de réaliser un film de quelques nm sur une surface de plusieurs mm² et à fortiori de plusieurs dizaines de cm². En effet, il n'existe pas de matériau suffisamment rigide à ces épaisseurs pour être manipulé. Pour la structure SOI, la limitation réside dans l'imparfaite compliance du substrat. En effet, celle-ci est liée à la capacité de l'isolant de se déformer (voire de fluer) pour pouvoir absorber des contraintes. Pour arriver à ce résultat, on doit avoir recours à des traitements thermiques à des températures élevées et/ou à des compositions adaptées (par exemple, dopage B et P dans le cas d'un isolant de type SiO₂). Ces traitements thermiques ne sont pas toujours compatibles avec la couche à épitaxier. Pour le troisième groupe de substrats, la difficulté est d'obtenir un collage sur une grande surface sans défaut et d'amincir la couche jusqu'à une très faible épaisseur. De plus, cette technique demande un très bon contrôle de la désorientation cristalline entre les deux substrats si l'on veut bien maîtriser le nombre et la nature des dislocations qui donnent le caractère compliant à ce type de structure.

Il est connu par ailleurs qu'une liaison intime entre deux matériaux peut être obtenue par adhésion moléculaire. Plusieurs cas peuvent se rencontrer en fonction des terminaisons présentes en surface au moment du collage. On parle par exemple de collage hydrophile ou hydrophobe.

L'hydrophilie de la surface est généralement obtenue à l'aide de nettoyages chimiques dont l'objectif est de saturer la surface en groupements hydroxyles OH (par exemple pour le silicium une densité surfacique de 4,6/nm²). Des molécules d'eau peuvent alors s'adsorber naturellement sur ces sites. La mise en contact de deux surfaces, ainsi préparées, entraîne leur adhésion avec une énergie de collage significative (0,1 J/m² dans le cas d'un collage oxyde de silicium - oxyde de silicium) dès la température ambiante. Les traitements thermiques postérieurs permettent un renforcement de celui-ci du fait d'une évolution des liaisons présentes à l'interface. Ainsi, dans le cas de collage SiO₂-SiO₂, des traitements thermiques à basse température, typiquement inférieure à 300°C, entraînent le rapprochement des deux surfaces via des liaisons hydrogènes entre les groupements hydroxyles en vis-à-vis via l'apparition des premières liaisons Si-O-Si. L'énergie de collage augmente alors régulièrement avec la température pour atteindre une énergie de collage de 2 J/m² à 900°C.

Par opposition, dans le cas d'un collage hydrophobe (c'est-à-dire un collage qui ne met pas en jeu des molécules d'eau ou des groupements hydroxyles), les surfaces sont généralement décapées avant collage de façon à éliminer tout l'oxyde natif. Les nettoyages utilisés pour le décapage laissent alors les surfaces saturées principalement en terminaisons Si-H par exemple pour du silicium. La tenue du collage n'est assurée que par une attraction de type Van der Waals et les énergies de collage alors mesurées à la température ambiante dans le cas d'un collage silicium-silicium (environ 10 mJ/m²) correspondent bien au calcul théorique. Lors d'une montée en température des liaisons Si-Si sont formées par reconstruction des deux surfaces en contact.

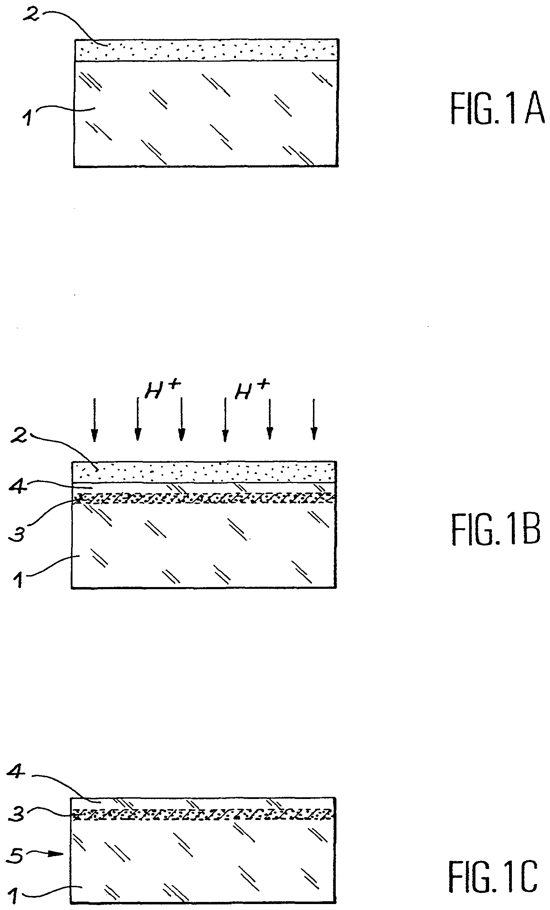

Ce mécanisme de collage peut se produire pour la majorité des matériaux à partir du moment où ils ont une rugosité et une planéité suffisamment faibles. Ces deux procédés utilisés montrent bien qu'il est possible de contrôler les forces de collage entre les différents matériaux mis en contact en fonction des traitements de surface, des traitements thermiques effectués et de la rugosité de surface. Un exemple de l'évolution de cette énergie de collage est donnée dans l'article "Mechanism for Silicon Direct Bonding" par Y. BACKLUND et al., paru dans la revue J. Micromech. Microeng. 2 (1992), pages 158-160 (voir en particulier la figure 1). Cette énergie de collage est déterminée par une méthode mettant en jeu la propagation d'une fissure au niveau de l'interface de collage sous l'effet de l'introduction d' une lame au niveau de l'interface de collage et parallèlement à cette interface.

Dès 1989, certains auteurs mentionnent la possibilité d'utiliser l'adhésion moléculaire pour réaliser un collage entre un film multicouche de GaAs/InGaAs/GaAs, réalisé auparavant sur un substrat bien adapté vis-à-vis de cette structure, et un support de silicium oxydé. Une préparation de surface spécifique permet d'obtenir de faibles forces de collage. On peut se référer à ce sujet à l'article "Characterization of Thin AlGaAs/InGaAs/GaAs Quantum-well Structures Bonded Directly to SiO2/Si and Glass Substrates" par J.F. KLEM et al., paru dans la revue J. Appl. Phys. 66 (1), 1er juillet 1989.

Il est également connu, par exemple par le document FR-A-2 681 472, que l'implantation par bombardement de gaz rare ou d'hydrogène dans un matériau semiconducteur, ou dans un matériau solide cristallin ou non (cf. FR-A-2 748 850), est susceptible de créer des microcavités ou microbulles à une profondeur voisine de la profondeur moyenne de pénétration des espèces implantées. La morphologie (dimension, forme, ...) de ces défauts peut évoluer au cours de traitements thermiques, en particulier ces cavités peuvent voir leurs tailles augmenter. Suivant la nature du matériau et surtout suivant ses propriétés mécaniques, ces cavités peuvent induire, suivant les conditions de traitement thermique, des déformations en surface nommées "blisters" dans la terminologie anglo-saxonne. Les paramètres les plus importants à contrôler pour obtenir ces déformations sont la dose de gaz introduite au cours de l'implantation, la profondeur à laquelle les espèces gazeuses sont implantées et le budget thermique fourni au cours de l'implantation. A titre d'exemple, une implantation d'hydrogène dans une plaque de silicium à une dose de 3.10¹⁶ H⁺/cm², pour une énergie de 40 keV, crée une couche enterrée continue de microcavités d'environ 150 nm d'épaisseur, à une profondeur moyenne de 330 nm. On entend par couche continue une couche contenant des microcavités réparties de façon homogène sur une certaine épaisseur. Ces microcavités sont de forme allongée (d'où leur nom de "platelets" en anglais). Elles possèdent par exemple une taille de l'ordre de 6 nm en longueur et de deux plans atomiques en épaisseur. Si un traitement thermique est effectué à 700°C durant 30 minutes, les microcavités grossissent et voient leurs tailles passer par exemple de l'ordre de 6 nm à plus de 50 nm en longueur et de quelques plans atomiques à 4-6 nm en épaisseur. Par contre, aucune perturbation de la surface implantée n'est observée. En effet, la taille et la pression à l'intérieur de ces cavités ne sont pas suffisantes pour induire des déformations en surface. On se trouve alors en présence d'une couche continue de défauts enterrés avec une zone contenant des microfissures (ou microcavités ou microbulles) mais sans aucune dégradation de la surface.

La présence de microcavités est observée également dans le cas d'une implantation réalisée par bombardement d'hélium à la profondeur moyenne d'implantation Rp dans un substrat, par exemple en silicium. Les cavités obtenues dans ce cas sont présentes même à des températures de recuit de l'ordre de 1000°C. Ces défauts fragilisent fortement le matériau en profondeur.

Le document US 5240876 décrit un procédé de corissance épitaxiale sur un substrat comportant une couche de SiGe, une couche isolante et un substrat dit substrat poignée. Une contrainte est créée dans la couche de SiGe par désaccord entre les atomes de silicium et les atomes de germanium.

### Exposé de l'invention

Afin de remédier aux inconvénients de l'art antérieur, il est proposé, selon la présente invention, un procédé de croissance par hétéro-épitaxie selon la revendication 1.

Le substrat compliant comporte une couche mince d'un matériau destiné à servir de germe à la croissance par hétéro-épitaxie d'un autre matériau. Cette couche mince est reliée au reste du substrat par des moyens de liaison, que l'on peut qualifier de région enterrée, telle que la couche mince et/ou les moyens de liaison accommode(nt) tout ou partie des contraintes provoquées lors de la croissance en épitaxie du matériau épitaxié, évitant ainsi de répercuter ces contraintes dans le matériau épitaxié.

Le caractère compliant d'une telle structure vis-à-vis d'un matériau déposé ensuite réside dans la prise en compte des différences de paramètre de maille, de coefficient de dilatation thermique et de la présence de la région enterrée. Par définition, l'objet de cette structure compliante est d'accommoder les contraintes du film de matériau déposé par une relaxation de celles-ci dans la région enterrée mais aussi éventuellement dans la couche mince.

Une variante du procédé consiste à introduire dans le film mince superficiel un élément étranger pour modifier les paramètres cristallographiques de la couche mince constituant le film germe pour l'épitaxie et par conséquent d'en modifier l'état de contrainte avant la croissance épitaxiale de la couche à obtenir.

Dans une application privilégiée, la couche mince est en un premier matériau cristallin et est destinée à servir de germe pour la croissance hétéro-épitaxiale d'un deuxième matériau cristallin constituant ladite structure. Cette couche mince peut être une couche précontrainte par introduction d'un élément étranger audit premier matériau cristallin afin de favoriser la compliance dudit substrat. L'élément étranger peut être introduit par implantation par bombardement et/ou introduit par diffusion. Cette implantation peut être réalisée à travers un oxyde sacrificiel. Cet élément étranger peut être un dopant de la couche mince. Le premier matériau cristallin peut notamment être un semiconducteur par exemple Si ou GaAs. Un tel substrat compliant peut avantageusement servir à la croissance hétéro-épitaxiale d'un matériau cristallin choisi parmi GaN, SiGe, AlN, InN et SiC.

### Brève description des dessins

L'invention sera mieux comprise et d'autres avantages et particularités apparaîtront à la lecture de la description qui va suivre, donnée à titre d'exemple non limitatif, accompagné des dessins annexés parmi lesquels :
- les figures 1A à 1C illustrent un exemple de réalisation d'un substrat compliant, non couvert par les revendications, la zone de liaison étant une couche de microcavités ;
- les figures 2A à 2C illustrent un premier exemple de réalisation d'un substrat compliant pour un procédé selon la présente invention, la zone de liaison comprenant une interface de collage ;
- la figure 3 représente un substrat compliant pouvant être utilisé selon la présente invention, la zone de liaison comprenant une interface de collage et une couche intermédiaire ;
- la figure 4 représente un substrat compliant pouvant être utilisé selon la présente invention, la zone de liaison comprenant une interface de collage entre deux couches intermédiaires ;
- la figure 5 est un diagramme illustrant l'évolution de l'énergie de collage, pour un collage SiO₂- SiO₂, en fonction de la température et de la rugosité de surface.

### Description détaillée de modes de réalisation de l'invention

A titre d'exemple préférentiel, le reste de la description va porter sur la réalisation de substrats compliants pour des dépôts de matériaux par hétéro-épitaxie. Mais, dans une application non couverte par les revendications, il est apparu qu'un tel substrat compliant peut, dans son principe, être utilisé pour l'absorption de contraintes dues à d'autres causes qu'une croissance d'un matériau par épitaxie. En fait, ce substrat compliant peut être utilisé pour recevoir une structure quelconque amenant des contraintes.

Un tel substrat compliant peut comporter un support et au moins une couche mince, formée en surface dudit support et destinée à recevoir, de manière solidaire, une structure amenant des contraintes, le support et la couche mince étant reliés l'un à l'autre par des moyens de liaison tels que les contraintes amenées par ladite structure sont tout ou partie absorbées par la couche mince et/ou par les moyens de liaison, caractérisé en ce que lesdits moyens de liaison comprennent au moins une zone de liaison choisie parmi les zones de liaison suivantes : une couche de microcavités et/ou une interface de collage dont l'énergie de collage est contrôlée pour permettre l'absorption desdites contraintes.

Dans une réalisation non couverte par les revendications, la zone de liaison peut être une couche de défauts, par exemple une couche de microcavités. La couche de défauts peut être créée par implantation par bombardement d'une ou de plusieurs espèces gazeuses. Ces espèces gazeuses peuvent être choisies parmi les gaz rares, l'hydrogène et le fluor. Des dopants peuvent être associés à l'espèce gazeuse ou aux espèces gazeuses. On peut en outre procéder à une diffusion de l'espèce gazeuse implantée ou des espèces gazeuses implantées. L'implantation peut être suivie d'un traitement thermique pour permettre de faire évoluer les défauts. L'implantation par bombardement peut être notamment réalisée au travers de la surface du substrat, la région comprise entre la surface du substrat et la couche de défauts fournissant ladite couche mince. Eventuellement, la région comprise entre la surface du substrat et la couche de défauts est amincie pour constituer ladite couche mince. L'implantation par bombardement peut aussi être réalisée au travers d'une couche sacrificielle supportée par ladite surface du substrat, ladite couche sacrificielle pouvant être ensuite éliminée.

L'implantation peut être réalisée au travers de la surface du substrat, cette surface supportant une première couche mince, la région comprise entre la surface du substrat et la couche de microcavités fournissant une deuxième couche mince. La couche de microcavités peut être réalisée au voisinage de l'interface entre la première couche mince et le substrat. L'implantation par bombardement peut être réalisée au travers d'une couche sacrificielle supportée par la première couche mince, ladite couche sacrificielle étant ensuite éliminée.

L'énergie de collage peut être contrôlée par préparation de surface et/ou par traitement thermique et/ou par créations de défauts à cette interface. Ces défauts peuvent être créés par exemple par implantation par bombardement et/ou par défauts de collage. Cette création de défauts permet généralement de fragiliser l'interface de collage. La préparation de surface peut être un contrôle de la rugosité et/ou de l'hydrophilie. La rugosité des plaques peut être obtenue par attaque chimique avec HF par exemple. L'hydrophilie peut être obtenue par nettoyage chimique du type RCA. La zone de liaison peut comprendre en outre au moins une couche intermédiaire entre la couche mince et le support. La couche intermédiaire peut être élaborée de telle façon qu'elle soit constituée d'inhomogénéités aptes à relâcher les contraintes. On peut citer par exemple la présence de joints de grains, de colonnes de croissance, d'inclusions... Cette couche peut être gravée sur tout ou partie de sa surface. La couche intermédiaire peut être une couche métallique ou une couche d'un alliage métallique.

Les moyens de liaison peuvent comprendre une couche de microcavités et une interface de collage disposée soit au-dessus soit au-dessous de la couche de microcavités.

On présente d'abord, y compris en liaison avec les figures 1A - 1C, un mode de réalisation, non couvert par les revendications, selon lequel on obtient un film de faible épaisseur à partir d'un substrat dans lequel on réalise une implantation d'espèces (par exemple des ions) susceptibles de créer, à une profondeur voisine de la profondeur moyenne de pénétration des espèces, une couche de défauts délimitant, entre la surface du substrat et elle-même, un film de faible épaisseur. Les espèces sont choisies de telle sorte que la couche de défauts créés soit susceptible d'accommoder les contraintes auxquelles le film de faible épaisseur peut être soumis. Le rôle de la couche de défauts est de plus de supporter le film de faible épaisseur (action verticale, perpendiculaire à la surface), tout en le laissant libre de contraintes dans le plan horizontal (parallèlement à la surface). Il peut être nécessaire, dans certains cas, d'appliquer un traitement thermique au substrat après l'étape d'implantation de façon à faire croître, par exemple, la taille des défauts, de les faire coalescer en amas de taille plus élevée, de modifier leur distribution de façon à rendre la couche plus adaptée à l'accommodement des contraintes.

On choisira préférentiellement des espèces parmi les gaz rares ou l'hydrogène, ou une combinaison des deux, qui sont connus pour permettre la création de défauts de type microcavités. Dans ce cas, on choisira une dose suffisante pour créer ces microcavités mais plus faible que la dose critique au-dessus de laquelle l'implantation des espèces est susceptible d'induire des déformations de la surface telles que les cloques (dénommées "blisters" en anglais). A titre d'exemple, dans le cas du silicium on peut choisir d'implanter des ions hydrogène à une dose de 3.10¹⁶/cm². Cependant, il faut préciser que cette dose critique dépend des conditions d'implantation et de la nature du dopage.

L'épaisseur du film est déterminée par le choix de l'énergie d'implantation. Afin de réaliser un film très fin (ce qui est nécessaire pour assurer une bonne compliance), on choisira une énergie d'implantation faible. Par exemple, dans le cas du silicium et des ions hydrogène, on choisira préférentiellement une énergie dans la gamme allant de 1 keV à 10 keV, gamme qui permet de réaliser des films d'épaisseur comprise entre 5 nm et 60 nm. On pourra aussi obtenir l'épaisseur désirée de film par amincissement (polissage, attaque chimique, oxydation sacrificielle) d'un film obtenu par implantation à une énergie plus élevée que celle qui aurait fourni directement l'épaisseur désirée.

Dans certains cas, il peut être avantageux d'implanter au travers d'une couche sacrificielle, par exemple une couche d'oxyde de silicium. Dans ce cas, il peut ne plus être nécessaire d'utiliser de très faibles énergies. L'élimination de la couche sacrificielle peut être suffisante pour se retrouver avec un film superficiel très mince.

Les figures 1A à 1C sont illustratives de ce dernier exemple. La figure 1A représente, vu de côté, un substrat 1, par exemple en silicium monocristallin, recouvert d'une couche d'oxyde de silicium 2 jouant le rôle de couche sacrificielle. La figure 1B représente une étape d'implantation ionique, par des ions d'hydrogène, du substrat 1 au travers de la couche d'oxyde 2. L'implantation est réalisée dans les conditions définies ci-dessus. On obtient une couche 3 de microcavités ou de microbulles définissant une couche ou film mince 4 adjacente à la couche d'oxyde 2. A cause de la présence de cette couche d'oxyde, l'épaisseur de la couche mince 4 peut être réduite et très précisément ajustée. La couche d'oxyde 2 est ensuite éliminée par attaque chimique et l'on obtient le substrat compliant 5 représenté à la figure 1C où l'ensemble formé par la couche de microcavités 3 et la couche mince 4 (servant de germe pour un matériau à épitaxier) constitue une couche compliante. Eventuellement, on peut procéder à un traitement thermique pour augmenter la taille des microcavités de la couche 3.

Pour certaines applications, l'implantation ionique peut aussi être réalisée au travers de deux couches monocristallines. Une première couche monocristalline, constituée dans le substrat lui-même, possède une épaisseur comprise entre la surface du substrat et la couche de microcavités induites par l'implantation. Une deuxième couche monocristalline peut être déposée ou reportée sur le substrat. A titre d'exemple, on peut choisir comme substrat une structure composée d'une fine couche de GaAs (par exemple de 3 nm d'épaisseur) reportée sur un substrat de silicium par une méthode telle que celle décrite dans le document FR-A-2 681 472 associée à un amincissement à l'aide de couches sacrificielles. Ensuite, une couche sacrificielle d'oxyde de silicium est déposée sur la structure afin de permettre d'implanter l'hydrogène à la profondeur désirée. On réalise l'implantation d'hydrogène dans le silicium, en traversant la couche sacrificielle d'oxyde et la couche de GaAs, pour créer les microcavités dans le silicium mais à une profondeur très proche de celle de l'interface GaAs/Si, par exemple une profondeur de l'ordre de quelques nm, voire quelques dizaines de nm. Une variante de réalisation peut consister à créer les microcavités au voisinage de l'interface entre GaAs et silicium.

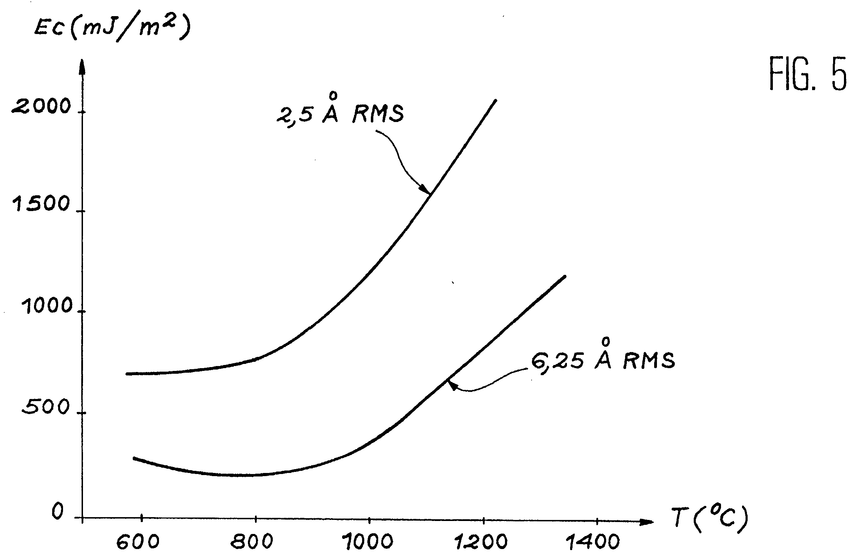

Comme indiqué précédemment les forces de collage sont fonction de nombreux paramètres (nature des espèces chimiques en surface, budget thermique fourni, rugosité de surface de départ). Cependant, ces forces peuvent être contrôlées de façon à pouvoir contrôler l'énergie de collage. On pourra donc accommoder ces forces de collage par rapport à la contrainte provoquée par la présence d'une couche mince épitaxiée d'un matériau et induite par des différences de paramètre de maille, de coefficient de dilatation thermique, mais aussi en tenant compte des contraintes induites par le collage par adhésion moléculaire lui-même. A titre d'exemple, dans le cas d'un collage hydrophile de plaques de silicium monocristallin et en utilisant le procédé de fabrication d'un film mince de matériau semiconducteur tel que défini dans le document FR-A-2 681 472, on peut obtenir une couche très mince de silicium (inférieure à 10 nm) sur une couche d'oxyde de très faible épaisseur (inférieure à 5 nm). L'originalité dans ce cas par rapport au procédé divulgué par le document FR-A-2 681 472 réside dans le contrôle des forces de collage en final, c'est-à-dire après la fracture par recuit à basse température (typiquement 450°C pendant 30 minutes pour une dose implantée d'hydrogène de l'ordre de 6.10¹⁶H⁺/cm²) et polissage mécano-chimique. Un exemple des forces de collage qui peuvent être obtenues sur les courbes de la figure 5. Par exemple, dans le cas d'un collage de SiO₂-SiO₂ avec une rugosité de surface de 6,25 Å rms (mesure AFM sur des surfaces analysées de 1x1 µm) pour les deux surfaces mises en contact, des énergies de liaison de l'ordre de 250 mJ/m² sont obtenues même après un traitement à 800°C.

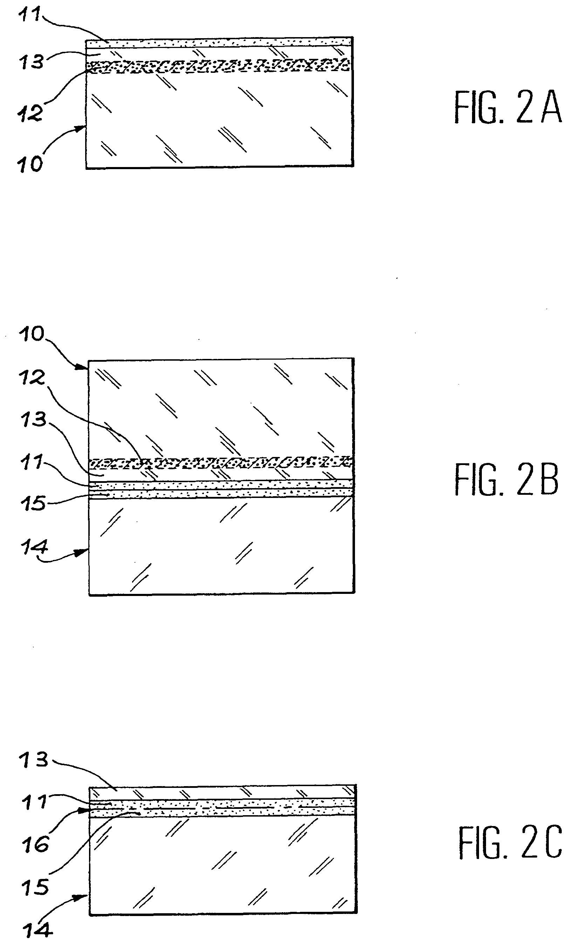

Les figures 2A à 2C illustrent cet exemple de réalisation. La figure 2A représente, vu de côté, un substrat 10 en silicium monocristallin dont une face est recouverte d'une très fine couche d'oxyde de silicium 11. On procède, au travers de la couche d'oxyde 11, à une implantation d'ions hydrogène destinée à induire une zone de fracture. On obtient une couche de microcavités 12 définissant entre elle et la couche d'oxyde 11, une région très fine 13 de silicium. La figure 2B montre, vu également de côté, un autre substrat de silicium 14 recouvert d'une fine couche d'oxyde de silicium 15. Les substrats 10 et 14 sont solidarisés par adhésion moléculaire de leurs couches d'oxyde 11 et 15. Ensuite, grâce à un traitement thermique approprié, on procède à la coalescence des microcavités de la couche 12 pour obtenir une fracture et la séparation du substrat 10 en deux parties. La face libre de la région 13 est polie pour constituer une couche mince destinée à l'hétéro-épitaxie (voir la figure 2C). Les couches d'oxyde 11 et 15 sont liées par l'interface de collage 16.

Il faut préciser que la structure film mince servant de germe/zone de liaison avec interface de collage/substrat peut être obtenue par d'autres méthodes que le procédé décrit dans le document FR-A-2 681 472. On peut citer à titre indicatif les méthodes basées sur le collage par adhésion moléculaire et l'amincissement par rectification et polissage. On peut également utiliser des couches minces reportées par épitaxial lift-off. De nombreux exemples existent dans la littérature, en particulier pour obtenir des films minces de matériaux III-V, comme par exemple le GaAs. On peut aussi avoir recours à l'utilisation d'une poignée support pour transférer les couches minces, servant de germe, de leur substrat de base vers la structure qui va devenir compliante.

Pour contrôler les forces de collage on peut également jouer sur le nombre de défauts de collage (c'est-à-dire des zones non collées) qui sont présentes à cette interface.

Une des solutions proposées précédemment est d'obtenir des forces de collage, entre le film mince qui va servir de germe et le support, assez faibles pour que le film mince puisse absorber des contraintes sans toutefois se décoller.

Une variante à ce procédé consiste à jouer sur ces forces de collage mais aussi sur la présence de couches intermédiaires. Ces couches intermédiaires pouvant renforcer le caractère compliant de la structure. Plus précisément, on tient compte dans ce cas, non seulement des forces de collage entre le film germe et la surface, mais on utilise aussi pour accommoder les contraintes les forces d'adhérence entre les différentes couches ainsi que la nature même des différentes couches minces.

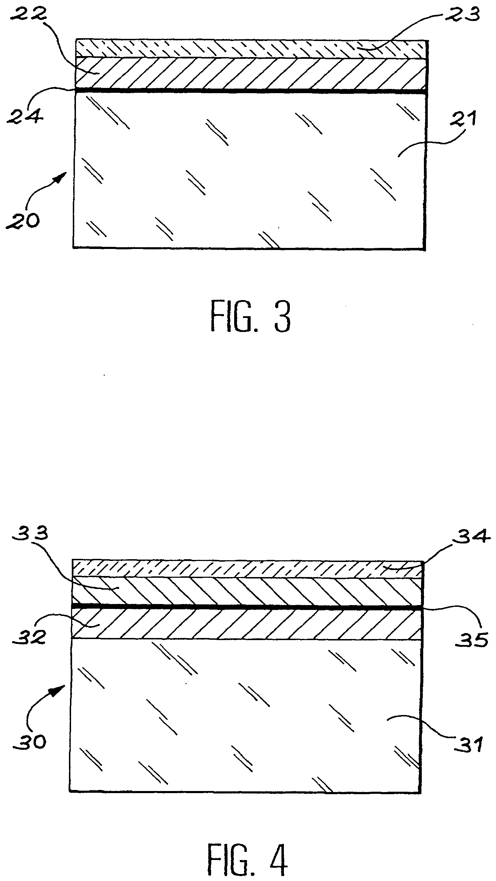

La figure 3 représente, vu de côté, un tel substrat compliant. Le substrat compliant 20 comprend un support 21, une couche intermédiaire 22 recouverte d'une couche mince 23 destinée à servir de germe pour une hétéro-épitaxie. La couche intermédiaire 22 est liée au support 21 par une interface de collage 24.

A titre d'exemple, on peut utiliser comme couche intermédiaire 22 un film métallique dont les propriétés mécaniques (déformation) sont telles qu'il peut encaisser une partie importante des contraintes. Par exemple, on peut utiliser le procédé décrit dans le document FR-A-2 681 472 pour obtenir le film mince 23 de semiconducteur servant de germe, mais en utilisant pour solidariser le film mince 23 sur la couche intermédiaire 22 un composé métallique à base de Au (95%) - Sn (5%) ou un composé à base de Al (5%) - Cu (95%). Ces composés métalliques ont la propriété d'être visqueux dans une large gamme de température compatible avec les températures auxquelles sont généralement réalisées les épitaxies (900-1000°C). On peut également indiquer à titre d'exemple l'utilisation de Pd, Pt ou de siliciures ou des alliages métalliques ou des alliages métal-substrat.

Une couche intermédiaire peut également recouvrir la partie du substrat formant le support proprement dit. C'est ce que montre la figure 4 où le substrat compliant 30 comprend une partie support 31 recouverte d'une première couche intermédiaire 32, d'une seconde couche intermédiaire 33 et de la couche mince servant de germe 34. L'interface de collage 35 se situe alors entre les deux couches intermédiaires 32 et 33. Ces couches intermédiaires peuvent être de même nature ou de natures différentes.

La fabrication de la couche intermédiaire sur le film mince et éventuellement sur le substrat support se fait avant le transfert de la structure couche intermédiaire/film mince servant de germe sur le substrat support. La couche intermédiaire est un solide de nature amorphe, polycristalline, ou cristalline. Elle peut être formée de une ou plusieurs sous-couches d'un même matériau ou d'un matériau différent et/ou être constituée d'une ou de plusieurs interfaces.

L'élaboration de la couche intermédiaire sur le film mince adaptable et éventuellement sur le substrat support peut être réalisée :
- soit par les techniques classiques de dépôt sous vide de couches minces (évaporation, pulvérisation cathodique, CVD, MBE,...),
- soit par les techniques de dépôt électrochimique (électrolyse, électroless,...),
- soit par les techniques de report de couches minces : collage par adhésion moléculaire puis amincissement, collage puis amincissement par un procédé tel que décrit dans le document FR-A-2 681 472, collage de la couche intermédiaire (déjà conditionnée en couche mince) via une poignée servant de support et élimination de la poignée,
- soit par transformation d'une certaine épaisseur à partir de la surface. Cette transformation peut être par exemple une oxydation ou une nitruration. Si on utilise une oxydation, elle peut être soit thermique, soit anodique ou obtenue par une autre technique (plasma oxygène, implantation d'oxygène,...). L'oxydation peut être réalisée également par la combinaison de plusieurs techniques d'oxydation,
- par une méthode permettant de fabriquer une couche poreuse déformable.

Dans la réalisation d'un substrat compliant, l'épaisseur du film superficiel peut être extrêmement critique. Dans certains cas, il est nécessaire de pouvoir réaliser des films superficiels de très faible épaisseur. Plusieurs méthodes peuvent être utilisées pour amincir des film minces. On peut citer de manière non exhaustive : l'abrasion ionique, la gravure chimique, la gravure assistée par plasma, l'ablation assistée par laser, la réalisation d'une couche sacrificielle (par oxydation, nitruration du film superficiel...) et retrait par diverses voies de cette couche sacrificielle.

Dans une application où la couche mince servant de germe est un film de silicium, ce film peut être le film supérieur d'une structure silicium-sur-isolant, réalisé par la technique SIMOX ou par un procédé d'adhésion moléculaire, dit "wafer bonding" en anglais, par exemple un procédé tel que le procédé décrit dans le document FR-A-2 681 472. Dans ce cas, l'épaisseur du film de silicium avant amincissement est par exemple de l'ordre de 0,2 µm. Un traitement thermique de ce film superficiel de silicium à 1000°C, pendant 70 minutes, en atmosphère de vapeur d'eau, entraîne la formation d'un film d'oxyde de silicium d'environ 0,4 µm d'épaisseur. De ce fait, le film superficiel de silicium est aminci jusqu'à une fine épaisseur de l'ordre de 1 nm à quelques dizaines de nm. Le retrait chimique du film de silice en surface est effectué par attaque à l'acide fluorhydrique à 10% pendant 10 minutes. Cette étape d'amincissement du film de silicium peut être avantageusement complétée dans le cas d'un film très mince de silicium par un traitement thermique, à haute température, de la surface sous atmosphère d'hydrogène. Par exemple, un traitement à une température de l'ordre de 1150°C pendant 10 minutes permet une reconstruction cristalline de surface libre du silicium. Dans le même temps, on met en évidence un amincissement du film de silicium de quelques nanomètres.

Dans l'approche de la compliance, un des principes est de permettre la relaxation des contraintes, liées à l'épitaxie, grâce au(x) film(s) de compliance. Il peut alors être avantageux d'induire avant l'épitaxie une contrainte dans le film superficiel servant de germe, à température ambiante, par une modification des paramètres physiques, voire même de la nature chimique, en fonction du type et de la nature du dépôt qui sera effectué. Ces modifications sont réalisées dans le but de favoriser la relaxation ultérieure des contraintes du dépôt. En effet, une précontrainte du matériau permet de favoriser la génération de dislocations dans le(s) film(s) superficiel(s) de compliance ou aux interfaces de ces films.

En général, l'épitaxie est réalisée à une température de plusieurs centaines de degrés. Le critère d'adaptation de maille n'est donc pas à prendre en compte à la seule température ambiante. Il est important d'estimer le rôle des contraintes d'origine thermique liées par exemple à la différence de dilatation thermique d'entre les divers films et le support mécanique (substrat).

Dans cette optique, on peut utiliser le fait qu'il est possible de modifier le paramètre cristallin du film superficiel à partir d'une implantation par bombardement d'un élément dans la matrice cristalline du film superficiel, complétée éventuellement par une diffusion thermique de l'élément. Une variante à l'implantation par bombardement serait d'utiliser des procédés basés sur la seule diffusion thermique d'éléments, tel que la diffusion de dopant dans le silicium. A titre d'exemple d'implantation ionique, on peut citer celui du bore dans le silicium monocristallin. Celui-ci entraîne une diminution de la maille cristalline de 0,014 Å/% atomique de l'espèce introduite. Si le film superficiel est fortement adhérent au support mécanique, le film de silicium sera alors mis dans un état de tension. De la même façon, l'effet d'implantation du germanium sera d'augmenter la maille cristalline de 0,0022 Å/% atomique. Si le film superficiel est fortement adhérent au support mécanique, le film de silicium sera alors mis dans un état de compression.

Dans le cas du film mince de silicium, réalisé pour la compliance en amincissant par oxydation sacrificielle comme décrit auparavant, l'implantation pourra être réalisée avantageusement avant le retrait de l'oxyde. Le film d'oxyde sert alors de film de protection pendant le traitement thermique de diffusion de l'élément implanté. A titre d'exemple, une implantation de bore à une énergie de l'ordre de 110 keV, avec une dose de l'ordre de quelques 10¹⁵/cm² à quelques 10¹⁶/cm², à travers la couche d'oxyde, d'épaisseur voisine de 0,4 µm, permet d'enrichir en bore le film de silicium très fin, par mise en coïncidence de la profondeur de ce film avec la profondeur d'implantation ionique. Des contraintes de quelques 10⁸ MPa peuvent ainsi être générées dans le film mince de silicium.

## Revendications

1. Procédé de croissance par hétéro-épitaxie comportant :
- la réalisation d'un substrat compliant (20,30) comprenant un support (14, 21, 31) et au moins une couche mince (13, 23, 34) formée en surface dudit support, la couche mince étant en un premier matériau servant de germe à ladite croissance par hétéro-épitaxie d'un deuxième matériau, le support et la couche mince étant reliés l'un à l'autre par des moyens de liaison (11, 15, 16 ; 24, 35) pour absorber ou accomoder tout ou partie des contraintes provoquées dans le deuxième matériau lors de sa croissance hétéro-épitaxiale par une différence de paramètres de maille lesdits moyens de liaison comprennant deux couches d'oxyde collées par adhésion moléculaire et dont l'interface de collage a une énergie de collage permettant au substrat compliant d'absorber ou d'accommoder au moins une partie desdites contraintes, la couche mince pouvant ainsi absorber des contraintes sans se décoller,
- la réalisation de la croissance hétéro-épitaxiale du deuxième matériau sur la couche mince de premier matériau du substrat compliant, celui-ci absorbant ou accommodant au moins une partie desdites contraintes, évitant de répercuter au moins une partie de ces contraintes dans ledit deuxième matériau.

2. Procédé selon la revendication 1, ladite couche mince (13, 23, 34) étant en un premier matériau cristallin et ledit deuxième matériau étant un matériau cristallin.

3. Procédé selon la revendication 2, ladite couche mince étant une couche précontrainte contenant un élément étranger audit premier matériau cristallin, la présence dudit élément étranger favorisant la compliance dudit substrat.

4. Procédé selon la revendication 3, ledit élément étranger étant un dopant de la couche mince.

5. Procédé selon l'une quelconque des revendications 2 à 4, ledit premier matériau cristallin étant un semiconducteur.

6. Procédé selon l'une quelconque des revendications 2 à 5, le deuxième matériau cristallin étant choisi parmi GaN, SiGe, AlN, InN et SiC.

## Patentansprüche

1. Verfahren zur Züchtung mittels Heteroepitaxie, umfassend:
- die Herstellung eines biegsamen Substrats (20, 30), umfassend einen Träger (14, 21, 31) und wenigstens eine dünne Schicht (13, 23, 34), die an der Oberfläche des Trägers gebildet ist, wobei die dünne Schicht aus einem ersten Material ist, das als Keim für die Züchtung eines zweiten Materials mittels Hetereoepitaxie dient, wobei der Träger und die dünne Schicht miteinander durch Verbindungsmittel (11, 15, 16; 24, 35) zum vollständigen oder teilweisen Absorbieren oder Aufnehmen von Spannungen verbunden sind, die in dem zweiten Material während seiner heteroepitaktischen Züchtung durch eine Differenz von Gitterparametern ausgelöst werden, wobei die Verbindungsmittel zwei Oxidschichten umfassen, die durch molekulare Adhäsion verbunden sind und deren Verbindungsgrenzfläche eine Verbindungsenergie hat, die es dem biegsamen Substrat ermöglicht, wenigstens einen Teil der Spannungen zu absorbieren oder aufzunehmen, wobei die dünne Schicht somit Spannungen absorbieren kann, ohne sich abzulösen,
- die Realisierung der heteroepitaktischen Züchtung des zweiten Materials auf der dünnen Schicht aus erstem Material des biegsamen Substrats, wobei dieses wenigstens einen Teil der Spannungen absorbiert oder aufnimmt, wodurch eine Weitergabe wenigstens eines Teils dieser Spannungen in das zweite Material vermieden wird.

2. Verfahren nach Anspruch 1, wobei die dünne Schicht (13, 23, 34) aus einem ersten kristallinen Material ist, und das zweite Material ein kristallines Material ist.

3. Verfahren nach Anspruch 2, wobei die dünne Schicht eine vorgespannte Schicht ist, die ein Element enthält, das zu dem ersten kristallinen Material unterschiedlich ist, wobei das Vorhandensein des unterschiedlichen Elements die Biegsamkeit des Substrats begünstigt.

4. Verfahren nach Anspruch 3, wobei das unterschiedliche Element ein Dotierungsmittel der dünnen Schicht ist.

5. Verfahren nach einem der Ansprüche 2 bis 4, wobei das erste kristalline Material ein Halbleiter ist.

6. Verfahren nach einem der Ansprüche 2 bis 5, wobei das zweite kristalline Material ausgewählt ist aus GaN, SiGe, AlN, InN und SiC.

## Claims

1. Process of hetero-epitaxial growth, comprising:
- fabricating a compliant substrate (20, 30) comprising a carrier (14, 21, 31) and at least one thin layer (13, 23, 34) formed on the surface of said carrier, said thin layer being in a first material and serving as a seed for said hetero-epitaxial growth of a second material, the carrier and the thin layer being joined one to another by joining means (3; 11, 15, 16; 24, 25) to absorb or accommodate all or part of the stresses brought to said second material during its hetero-epitaxial growth by differences in lattice parameters, said joining means comprising two oxide layers bonded by molecular adhesion, with a bonding interface having a bonding energy allowing the compliant substrate to absorb or accommodate all or part of said stresses, said thin layer thus absorbing stresses without becoming detached,
- performing said hetero-epitaxial growth of said second material on the thin layer of first material of the compliant substrate, this one absorbing or accommodating at least part of said stresses, avoiding the occurrence of at least of these stresses in said second material.

2. Process according to claim 1, said thin layer (13, 23, 34) being in a first crystalline material and said second material being a crystalline material.

3. Process according to claim 2, said thin layer being a pre-stressed layer containing an element foreign to said first crystalline material, the presence of said foreign element promoting the compliance of said substrate.

4. Process according to claim 3, said foreign element being a doping agent of the thin layer.

5. Process according to any of claims 2 to 4, said first crystalline material being a semiconductor.

6. Process according to any of claims 2 to 5, the second crystalline material being chosen from among GaN, SiGe, AlN, InN, and SiC.
